# EUROPEAN PATENT APPLICATION

(11) **EP 3 483 927 A1**
(43) Date of publication of application: **15.05.2019**
(21) Application number: 17841129.4
(22) Date of filing: 21.08.2017
(51) Int. Cl.: H01L 23/29, H01L 23/31, H01L 21/56

(54) **SEMICONDUCTOR PACKAGING STRUCTURE AND MANUFACTURING METHOD THEREFOR**

(30) Priority: 19.08.2016 CN 201610697554
(71) Applicant: Huawei Technologies Co., Ltd., Longgang District Shenzhen, Guangdong 518129 (CN)
(72) Inventor: CHEN, Cheng Ting, Shenzhen Guangdong 518129 (CN); CHANG, Sheng Chieh, Shenzhen Guangdong 518129 (CN); XIA, Yu, Shenzhen Guangdong 518129 (CN)
(74) Representative: Maiwald Patent- und Rechtsanwaltsgesellschaft mbH
(86) International application number: PCT/CN2017/098290
(87) International publication number: WO 2018/033157

(57) **Abstract**

Embodiments of the present invention provide a semiconductor package structure. The structure includes: a semiconductor component; a connection pad, disposed on the semiconductor component; a protective layer, including a first non-conductive material, a first part, and a second part, where the first part covers the semiconductor component except the connection pad, a surface of the first part is at a first height, the second part covers a periphery of the connection pad, a surface of the second part is at a second height, the first height is less than the second height, a middle part of the connection pad is exposed, and the first part and the second part are connected at an edge of the connection pad; a flat layer, including a second non-conductive material and covering the first part, where a surface of the flat layer is at the second height; an under bump metallization layer, including a first metallic material and covering the flat layer, the second part, and the middle part; and a rewiring layer, including a second metallic material and covering the under bump metallization layer.

## Description

### TECHNICAL FIELD

The present invention relates to the semiconductor field, and in particular, to a semiconductor package structure and a semiconductor package structure fabricating method.

### BACKGROUND

In semiconductor chip fabricating technologies, wafer level packaging means that all or most packaging test procedures are directly performed on a wafer before a wafer component is cut to fabricate individual components. Compared with a conventional procedure in which a wafer is first cut and then a packaging test is performed on an individual bare die obtained after the cutting, the wafer level packaging does not need any intermediate layer, filler, or lead frame and omits fabricating processes such as die bonding and wire bonding, so that material and labor costs can be greatly reduced. In addition, in the wafer level packaging, redistribution and bumping technologies are usually used as a wire-winding means for input/output (Input/Output, I/O) ports. Therefore, the wafer level packaging has advantages of a smaller package size and better electrical performance. However, in a wafer level packaging technology, a conducting wire is prone to break off, and a yield rate and reliability of a fabricated chip need to be improved.

### SUMMARY

Embodiments of the present invention provide a semiconductor package structure and a semiconductor package structure fabricating method. The semiconductor package structure has a higher yield rate and better reliability, and signals transmitted by using the semiconductor package structure are also more consistent.

According to a first aspect, an embodiment of the present invention provides a semiconductor package structure, including: a semiconductor component; a connection pad, disposed on the semiconductor component; a protective layer, including a first non-conductive material, a first part, and a second part, where the first part covers the semiconductor component except the connection pad, a surface of the first part is at a first height, the second part covers a periphery of the connection pad, a surface of the second part is at a second height, the first height is less than the second height, a middle part of the connection pad is exposed, the middle part includes a part on the connection pad except the periphery, and the first part and the second part are connected at an edge of the connection pad; a flat layer, including a second non-conductive material and covering the first part, where a surface of the flat layer is at the second height; an under bump metallization layer, including a first metallic material and covering the flat layer, the second part, and the middle part; and a rewiring layer, including a second metallic material and covering the under bump metallization layer.

The surface of the flat layer is flush with the surface of the second part. The flat layer makes up a height difference between the first part and the second part of the protective layer, so that the under bump metallization layer can cover a smoother surface, and a risk that the under bump metallization layer and the rewiring layer covering the under bump metallization layer distort, fracture, and peel off at an unsmooth part is reduced.

In a first possible implementation of the first aspect, the second non-conductive material includes silicon oxide. Compared with an organic material such as polyimide (Polyimide), using the silicon oxide to fabricate the flat layer can lead to higher smoothness precision, so as to further reduce a risk that the under bump metallization layer and the rewiring layer covering the under bump metallization layer distort, fracture, and peel off. This helps improve a yield rate and reliability of a plurality of rewiring layers. In addition, the rewiring layer becomes more even because of improvement in flatness, and signals transmitted by using the rewiring layer are also more consistent.

With reference to the first aspect or the first possible implementation of the first aspect, in a second possible implementation, the silicon oxide includes silicon dioxide.

With reference to any one of the first aspect, or the first and the second possible implementations of the first aspect, in a third possible implementation, the first non-conductive material includes silicon nitride.

With reference to any one of the first aspect, or the first to the third possible implementations of the first aspect, in a fourth possible implementation, the first metallic material includes at least one of copper, nickel, silver, or tin.

With reference to any one of the first aspect, or the first to the fourth possible implementations of the first aspect, in a fifth possible implementation, the second metallic material includes at least one of copper or aluminum.

According to a second aspect, an embodiment of the present invention provides a semiconductor package structure fabricating method, including: fabricating a semiconductor component; disposing a connection pad on the semiconductor component; fabricating a protective layer by using a first non-conductive material, where the protective layer includes a first part and a second part, and the fabricating a protective layer includes: covering the semiconductor component except the connection pad with the first part, so that a surface of the first part is at a first height; covering a periphery of the connection pad with the second part, so that a surface of the second part is at a second height, where the first height is less than the second height; and exposing a middle part of the connection pad, where the middle part includes a part on the connection pad except the periphery, and the first part and the second part are connected at an edge of the connection pad; fabricating a flat layer by using a second non-conductive material, where the fabricating a flat layer includes: covering the first part with the flat layer, so that a surface of the flat layer is at the second height; fabricating an under bump metallization layer by using a first metallic material, and covering the flat layer, the second part, and the middle part with the under bump metallization layer; and fabricating a rewiring layer by using a second metallic material, and covering the under bump metallization layer with the rewiring layer.

The flat layer makes up a height difference between the first part and the second part of the protective layer, so that the under bump metallization layer can cover a smoother surface, and a risk that the under bump metallization layer and the rewiring layer covering the under bump metallization layer distort, fracture, and peel off at an unsmooth part is reduced.

In a first possible implementation of the second aspect, the covering the first part with the flat layer, so that a surface of the flat layer is at the second height includes: covering the protective layer and the middle part with a second conductive material by using a chemical vapor deposition (CVD) process; polishing the second conductive material to the second height by using a chemical mechanical polishing (CMP) process; and removing, by using a photo lithography process and an etching process, the second conductive material covering the middle part.

With reference to the second aspect, or the first possible implementation of the second aspect, in a second possible implementation, the second non-conductive material includes silicon oxide. Compared with an organic material such as polyimide (Polyimide), using the silicon oxide to fabricate the flat layer can lead to higher smoothness precision, so as to further reduce a risk that the under bump metallization layer and the rewiring layer covering the under bump metallization layer distort, fracture, and peel off. This helps improve a yield rate and reliability of a plurality of rewiring layers. In addition, the rewiring layer becomes more even because of improvement in flatness, and signals transmitted by using the rewiring layer are also more consistent.

With reference to any one of the second aspect, or the first and the second possible implementations of the second aspect, in a third possible implementation, the silicon oxide includes silicon dioxide.

With reference to any one of the second aspect, or the first to the third possible implementations of the second aspect, in a fourth possible implementation, the first non-conductive material includes silicon nitride.

With reference to any one of the second aspect, or the first to the fourth possible implementations of the second aspect, in a fifth possible implementation, the first metallic material includes at least one of copper, nickel, silver, or tin.

With reference to any one of the second aspect, or the first to the fifth possible implementations of the second aspect, in a sixth possible implementation, the second metallic material includes at least one of copper or aluminum.

### BRIEF DESCRIPTION OF DRAWINGS

To describe the technical solutions in embodiments of the present invention or in the prior art more clearly, the following briefly describes the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a sectional schematic diagram of a package structure according to a first embodiment of the present invention;
FIG. 2 is a sectional schematic diagram of a semiconductor component, a connection pad, and a protective layer that are in FIG. 1;
FIG. 3 is a flowchart of a package structure fabricating method according to a second embodiment of the present invention;
FIG. 4 is a sectional schematic diagram of a structure in a fabricating process in FIG. 3;
FIG. 5 is another sectional schematic diagram of a structure in a fabricating process in FIG. 3; and
FIG. 6 is still another sectional schematic diagram of a structure in a fabricating process in FIG. 3.

### DESCRIPTION OF EMBODIMENTS

The following clearly and completely describes the technical solutions in embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

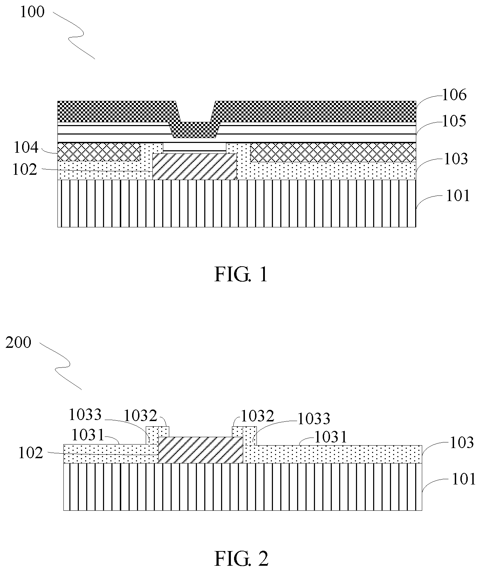

FIG. 1 is a sectional schematic diagram of a package structure 100 according to a first embodiment of the present invention. The package structure 100 includes a semiconductor component 101, a connection pad 102, a protective layer 103, a flat layer 104, an under bump metallization layer 105, and a rewiring layer 106.

In an embodiment, the semiconductor component 101 includes a wafer (Wafer). The connection pad 102 is disposed on the semiconductor component 101. The protective layer 103 includes a first non-conductive material. As shown by 200 in FIG. 2, the protective layer 103 includes a first part 1031 and a second part 1032. The first part 1031 covers the semiconductor component 101. A surface of the first part 1031 is at a first height. The second part 1032 covers a periphery of the connection pad 102 and is configured to ensure that the protective layer 103 covers all parts of the semiconductor component 101 except an area on which the connection pad is disposed. In an embodiment, from a top view, a surface of the connection pad is in a circular shape. The periphery is an outermost ring of the circular shape. In a process of fabricating a 28-nm semiconductor, a diameter of the connection pad is about 100 um, an outer diameter of the ring is the same as the diameter of the connection pad, and an inner diameter of the ring is about 80 um. A surface of the second part 1032 is at a second height. The first height is less than the second height. A middle part of the connection pad 102 is exposed. The middle part includes a part on the connection pad 102 except the periphery. In the process of fabricating a 28-nm semiconductor, from a top view, a diameter of the middle part is the same as the inner diameter of the ring. The first part 1031 and the second part 1032 are connected at an edge 1033 of the connection pad 102. In an embodiment, the first non-conductive material includes silicon nitride.

The flat layer 104 includes a second non-conductive material and covers the first part 1031. A surface of the flat layer 104 is at the second height, so that the surface of the flat layer 104 is flush with the surface of the second part 1032. The flat layer 104 makes up a height difference between the first part 1031 and the second part 1032 of the protective layer 103, so that the under bump metallization layer 105 can cover a smoother surface, and a risk that the under bump metallization layer 105 and the rewiring layer 106 covering the under bump metallization layer 105 distort, fracture, and peel off at an unsmooth part is reduced. In an embodiment, the second non-conductive material includes silicon oxide. For example, the silicon oxide is silicon dioxide. Compared with an organic material such as polyimide (Polyimide), using the silicon oxide to fabricate the flat layer 104 can lead to higher smoothness precision, so as to further reduce a risk that the under bump metallization layer 105 and the rewiring layer 106 covering the under bump metallization layer 105 distort, fracture, and peel off. This helps improve a yield rate and reliability of a plurality of rewiring layers. In addition, the rewiring layer 106 becomes more even because of improvement in flatness, and signals transmitted by using the rewiring layer 106 are also more consistent.

The under bump metallization layer 105 includes a first metallic material and covers the flat layer 104, the second part 1032, and the middle part of the connection pad 102. The first metallic material includes at least one of copper, nickel, silver, or tin. The rewiring layer 106 includes a second metallic material and covers the under bump metallization layer 105. In an embodiment, the second metallic material includes at least one of copper or aluminum.

The connection pad 102 is configured to connect to the rewiring layer 106 by using the under bump metallization layer 105, and the rewiring layer 106 is connected to an electrical conducting wire, so that the connection pad 102 is electrically connected to another electrical component. The under bump metallization layer 105 is configured to keep a value of resistance generated between the connection pad 102 and the rewiring layer 106 steady in different conditions (such as different voltage conditions).

In an embodiment, the package structure 100 includes a plurality of structures shown in FIG. 1. A plurality of semiconductor components 101, protective layers 103, flat layers 104, under bump metallization layers 105, and rewiring layers 106 in the structures shown in FIG. 1 are separately connected together. For example, the package structure 100 includes a structure A and a structure B that are shown in FIG. 1. The semiconductor component 101 in the structure A and the semiconductor component 101 in the structure B are connected together, the protective layer 103 in the structure A and the protective layer 103 in the structure B are connected together, and so on.

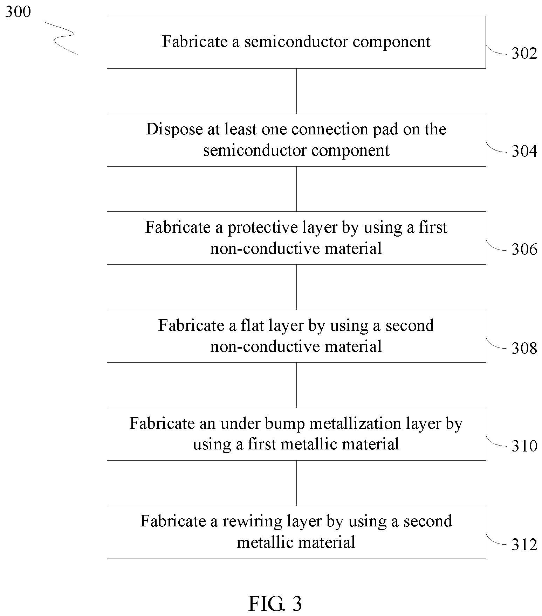

FIG. 3 is a flowchart 300 of a package structure fabricating method according to a second embodiment of the present invention. As shown in the figure, in step 302, a semiconductor component 101 is fabricated. In an embodiment, the semiconductor component 101 includes a wafer (Wafer). In step 304, a connection pad 102 is disposed on the semiconductor component. In step 306, a protective layer is fabricated by using a first non-conductive material. The protective layer includes a first part 1031 and a second part 1032. The semiconductor component 101 is covered with the first part 1031, so that a surface of the first part 1031 is at a first height. A periphery of the connection pad is covered with a second part 1302, so that a surface of the second part 1032 is at a second height. The first height is less than the second height, so that a middle part of the connection pad 102 is exposed. The middle part includes a part on the connection pad 102 except the periphery. The first part 1031 and the second part 1032 are connected at an edge 1033 of the connection pad 102. In an embodiment, the first non-conductive material includes silicon nitride.

In step 308, a flat layer 104 is fabricated by using a second non-conductive material. Specifically, the first part 1031 is covered with the flat layer 104, so that a surface of the flat layer 104 is at the second height. The flat layer 104 makes up a height difference between the first part 1031 and the second part 1032 of the protective layer, so that an under bump metallization layer 105 in a subsequent process can cover a smoother surface, and a risk that the under bump metallization layer 105 and a rewiring layer 106 covering the under bump metallization layer 105 distort, fracture, and peel off at an unsmooth part is reduced.

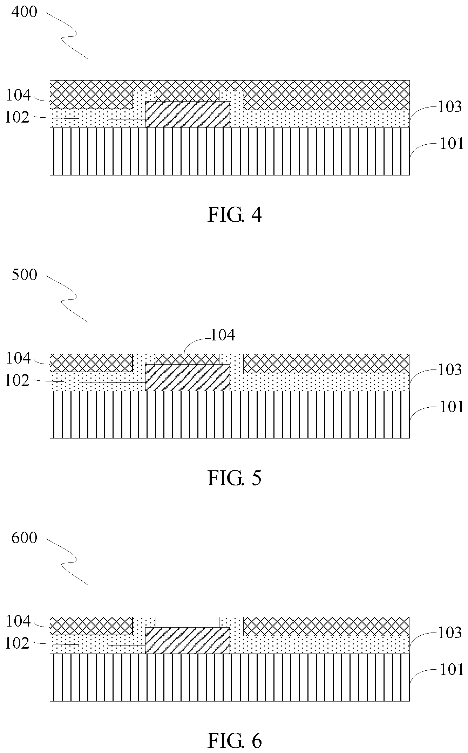

In an embodiment, that the first part 1031 is covered with the flat layer 104, so that a surface of the flat layer 104 is at the second height includes: as shown in FIG. 4, the protective layer 103 and the middle part of the connection pad 102 are covered with a second conductive material by using a chemical vapor deposition (CVD) process; as shown in FIG. 5, the second conductive material is polished to the second height by using a chemical mechanical polishing (CMP) process; and as shown in FIG. 6, the second conductive material covering the middle part of the connection pad 102 is removed by using a photo lithography process and an etching process. In an embodiment, the second non-conductive material includes silicon oxide. For example, the silicon oxide includes silicon dioxide. Compared with an organic material such as polyimide (Polyimide), using the silicon oxide to fabricate the flat layer can lead to higher smoothness precision, so as to further reduce a risk that the under bump metallization layer 105 and the rewiring layer 106 covering the under bump metallization layer 105 distort, fracture, and peel off. This helps improve a yield rate and reliability of a plurality of rewiring layers. In addition, the rewiring layer 106 becomes more even because of improvement in flatness, and signals transmitted by using the rewiring layer 106 are also more consistent.

In step 310, the under bump metallization layer 105 is fabricated by using a first metallic material, so that the flat layer 104, the second part 1032, and the middle part of the connection pad 102 are covered with the under bump metallization layer 105. In an embodiment, the first metallic material includes at least one of copper, nickel, silver, or tin. In step 312, the rewiring layer 106 is fabricated by using a second metallic material, so that the under bump metallization layer 105 is covered with the rewiring layer 106. The second metallic material includes at least one of copper or aluminum.

What is disclosed above is merely examples of the embodiments of the present invention, and certainly is not intended to limit the protection scope of the present invention. Therefore, equivalent variations made in accordance with the claims of the present invention shall fall within the scope of the present invention.

## Claims

1. A semiconductor package structure, comprising:
a semiconductor component;
a connection pad, disposed on the semiconductor component;
a protective layer, comprising a first non-conductive material, a first part, and a second part, wherein the first part covers the semiconductor component except the connection pad, a surface of the first part is at a first height, the second part covers a periphery of the connection pad, a surface of the second part is at a second height, the first height is less than the second height, a middle part of the connection pad is exposed, the middle part comprises a part on the connection pad except the periphery, and the first part and the second part are connected at an edge of the connection pad;
a flat layer, comprising a second non-conductive material and covering the first part, wherein a surface of the flat layer is at the second height;
an under bump metallization layer, comprising a first metallic material and covering the flat layer, the second part, and the middle part; and
a rewiring layer, comprising a second metallic material and covering the under bump metallization layer.

2. The package structure according to claim 1, wherein the second non-conductive material comprises silicon oxide.

3. The package structure according to claim 1 or 2, wherein the silicon oxide comprises silicon dioxide.

4. The package structure according to any one of claims 1 to 3, wherein the first non-conductive material comprises silicon nitride.

5. The package structure according to any one of claims 1 to 4, wherein the first metallic material comprises at least one of copper, nickel, silver, or tin.

6. The package structure according to any one of claims 1 to 5, wherein the second metallic material comprises at least one of copper or aluminum.

7. A semiconductor package structure fabricating method, comprising:
Fabricating a semiconductor component;
Disposing a connection pad on the semiconductor component;
Fabricating a protective layer by using a first non-conductive material, wherein the protective layer comprises a first part and a second part, and the fabricating a protective layer comprises: covering the semiconductor component except the connection pad with the first part, so that a surface of the first part is at a first height; covering a periphery of the connection pad with the second part, so that a surface of the second part is at a second height, wherein the first height is less than the second height; and exposing a middle part of the connection pad, wherein the middle part comprises a part on the connection pad except the periphery, and the first part and the second part are connected at an edge of the connection pad;
Fabricating a flat layer by using a second non-conductive material, wherein the fabricating a flat layer comprises: covering the first part with the flat layer, so that a surface of the flat layer is at the second height;
fabricating an under bump metallization layer by using a first metallic material, and covering the flat layer, the second part, and the middle part with the under bump metallization layer; and
fabricating a rewiring layer by using a second metallic material, and covering the under bump metallization layer with the rewiring layer.

8. The method according to claim 7, wherein the covering the first part with the flat layer, so that a surface of the flat layer is at the second height comprises:
covering the protective layer and the middle part with a second conductive material by using a chemical vapor deposition (CVD) process;
polishing the second conductive material to the second height by using a chemical mechanical polishing (CMP) process; and
removing, by using a photo lithography process and an etching process, the second conductive material covering the middle part.

9. The method according to claim 7 or 8, wherein the second non-conductive material comprises silicon oxide.

10. The method according to any one of claims 7 to 9, wherein the silicon oxide comprises silicon dioxide.

11. The method according to any one of claims 7 to 10, wherein the first non-conductive material comprises silicon nitride.

12. The package structure according to any one of claims 7 to 11, wherein the first metallic material comprises at least one of copper, nickel, silver, or tin.
